# EUROPEAN PATENT SPECIFICATION

(11) **EP 3 174 093 B1**
(45) Date of publication and mention of the grant of the patent: **28.10.2020**
(21) Application number: 16199913.1
(22) Date of filing: 22.11.2016
(51) Int. Cl.: H01L 23/427

(54) **COOLED POWER ELECTRONIC ASSEMBLY**
GEKÜHLTE LEISTUNGSELEKTRONIKANORDNUNG
ENSEMBLE ÉLECTRONIQUE D'ALIMENTATION REFROIDI

(30) Priority: 30.11.2015 US 201514953595
(43) Date of publication of application: 31.05.2017
(73) Proprietor: ABB Schweiz AG, 5400 Baden (CH)
(72) Inventor: Silvennoinen, Mika, 00380 Helsinki (FI); Manninen, Jorma, 00380 Helsinki (FI); Pakarinen, Joni, 00380 Helsinki (FI)
(74) Representative: Kolster Oy Ab

(56) References cited:
- WO-A2-2011/072297
- CN-A- 102 043 454
- US-A1- 2004 035 558
- US-A1- 2014 247 556
- US-B1- 6 189 601

## Description

### FIELD OF THE INVENTION

The present invention relates to power electronic assemblies, and particularly to power electronic assemblies with cooling.

### BACKGROUND OF THE INVENTION

Power electronic modules are widely used components in which multiple of power electronic switches or devices are placed in a single module. The switches of a power electronic module are wired inside the module in specified manner such that power electronic modules can be used in different circuit structures. Such circuit structures are, for example, power stages of different power converters. For that purpose, the power electronic modules may comprise different half-bridge, full bridge or other bridge topologies in which controllable switch components are internally connected with power diodes. The power electronic modules comprise also terminals, such as control terminals and power terminals that allow connecting the modules to other required circuitry and possibly to other modules.

The components inside a power electronic module are typically mounted on a substrate that is thermally connected to the base plate of the module. The base plate is a metallic piece integrated to the bottom of the module and it is intended to be attached to a surface of a cooling member, such as heat sink. The semiconductor switches inside the modules generate heat when the switches are operated. The switched currents can be over hundreds or even thousands of amperes and the voltage blocking ability of the power semiconductors of the module is several thousand volts. These semiconductor switches are further operated at a relatively high frequency of several thousand Hertz.

A proper thermal design is crucial for a reliable operation of power electronic modules. A violation of the temperature ratings can lead to a reduced safe operating area and consequently a sudden device failure or to a reduced operational lifetime. For example, IEC 60747-9 gives a range of temperature ratings for IGBTs like storage temperature, case temperature and virtual junction temperature. To keep the temperature of the module at a tolerable range, it is known to attach the module to a heat sink. This is performed by attaching the planar surface of the base plate or of the substrate to a corresponding planar surface of a heat sink. The heat transfer between the bottom surface of the module and the heat sink is enhanced by using a thermal interface material (TIM). Such material or layer is placed between the surfaces of base plate and heat sink or surfaces of substrate and heat sink if the module is without a base plate.

Thermal connection between two surfaces depends on several properties including their surface roughness (Ra) and surfaces' planarity. In practice the contact of two surfaces is imperfect and there are gaps filled with air in between them. Because air is poor thermal conductor the contact thermal resistance (Rth) can be reduced by making the contact surfaces perfectly smooth and planar (very expensive) and/or by replacing the air by a better thermal conducting substance.

As mentioned, power electronic modules' heat loss is dissipated mainly via its base plate that has to be in good thermal connection with cooling device like air cooled heatsink, liquid cold plate or thermosyphon heatsink. It is clear that thermal characteristics of the cooling device have to be designed according to both the PE module and its usage profile.

High speed motor drive has increased power electronic modules' heat losses because of higher switching frequency. Then high power cyclic applications have higher thermal induced stresses within the power electronic module. Conventional aluminum heat sinks' thermal characteristics are well known and utilized quite well too. However it is clear that the increasing heating power density (W/cm2) of power electronic modules require more efficient cooling solutions. Also, the common aluminum heatsinks' time constants are insufficient for the high power cyclic applications. Much faster response is needed to avoid excessive junction temperatures and to achieve long service life.

Specific heatsink designs have been developed to both reduce thermal resistance and enhance their power cycle response. These heatsink improvements relate e.g. to special cooling fin designs for enhanced surface area and/or enhanced heat transfer coefficient, combination of different construction materials (Al+Cu), and use of two-phase construction parts like heat-pipes for increased heat spreading within the heatsink. Especially the two-phase heatsinks are proven to work well in many thermally demanding applications.

The common heatsink design problem relates to insufficient cooling fin efficiency. Aluminum is relatively inexpensive material and easy to manufacture but its thermal conductivity (k∼200 W/mK) is often insufficient. Copper fins or base plate inserts (k∼380 W/mK) are therefore commonly considered but this increases the total weight and cost significantly.

Heatsinks can be manufactured from various materials but aluminum alloys and copper are the most common. Manufacturing technologies are numerous and these technologies can also be combined. Some common technologies include extrusion profiles, extrusion lamella-packs, stamped heatsinks, die casted heatsinks, skived fin heatsinks, folded fin heatsink, milled/machined heatsinks, crimped fin heatsink, bonded fin heatsinks (glued), brazed fin heatsinks (soldered) and forged heatsinks.

Heat-pipes and thermosyphons are combined to heatsinks to achieve higher heat transfer and spreading within the heatsink. Common heat pipe heatsink designs include the following, gundrilled straight or U-shape heatpipes in the heatsink base plate, heatsink base plate surface embedded heat pipes using dry fit, adhesive or solder and tower heat pipes.

Documents US 2004/0035558 A1 and US 6189601 B1 disclose cooling arrangements in which multiple of shaped heat pipes are used for transferring heat from the heat source to a cooling device. Document US 2014/0247556 A1 discloses a vapour chamber in connection with thermal management of an integrated circuit assembly. Document CN 102043454 A discloses a vapour chamber having multiple of condenser pipes arranged inside a mounting plate for cooling a CPU.

Although multiple of variants are available for cooling a power semiconductor module, a larger heat transfer capacity and a faster response time for cyclic load is still required to ensure the reliable operation of the power semiconductor module.

### BRIEF DESCRIPTION OF THE INVENTION

An object of the present invention is to provide a power electronic assembly so as to solve the above problems. The objects of the invention are achieved by a power electronic assembly which is characterized by what is stated in the independent claims. The preferred embodiments of the invention are disclosed in the dependent claims.

The invention is based on using a structure in which heat from the base plate of a power semiconductor module is removed using a vapour chamber having multiple of condenser pipes extending from the vapour chamber. The condenser pipes are attached to the vapour chamber such that the chamber and the multiple of pipes define a common volume for the working fluid inside the structure. The vapour chamber together with the multiple of condenser pipes are further supported in a mounting plate. The mounting plate enables the attachment of the power semiconductor module in the assembly such that heat from the power semiconductor component is reliably transferred to the vapour chamber.

An advantage of the electronic assembly of the invention is that the heat transfer capacity (W/cm^2 and W/cm^3) of the assembly is increased when compared to existing structures. Further, as the fluid evaporation section of the assembly can be made large, the response to cyclic heat load is increased. The thermal resistance from the power semiconductor module to the ambient is also low enabling efficient heat transfer. Further, the assembly of the invention has relatively low material and manufacturing costs.

### BRIEF DESCRIPTION OF THE DRAWINGS

In the following the invention will be described in greater detail by means of preferred embodiments with reference to the attached drawings, in which
Figure 1 shows a cross section of an example of a cooled power electric assembly;
Figure 2 shows a perspective view of the embodiment of Figure 1;
Figure 3 shows a cross section of another example of a cooled power electric assembly;
Figure 4 shows a perspective view of the embodiment of Figure 3; and
Figure 5 shows a cross section of an embodiment of the invention.

### DETAILED DESCRIPTION OF THE INVENTION

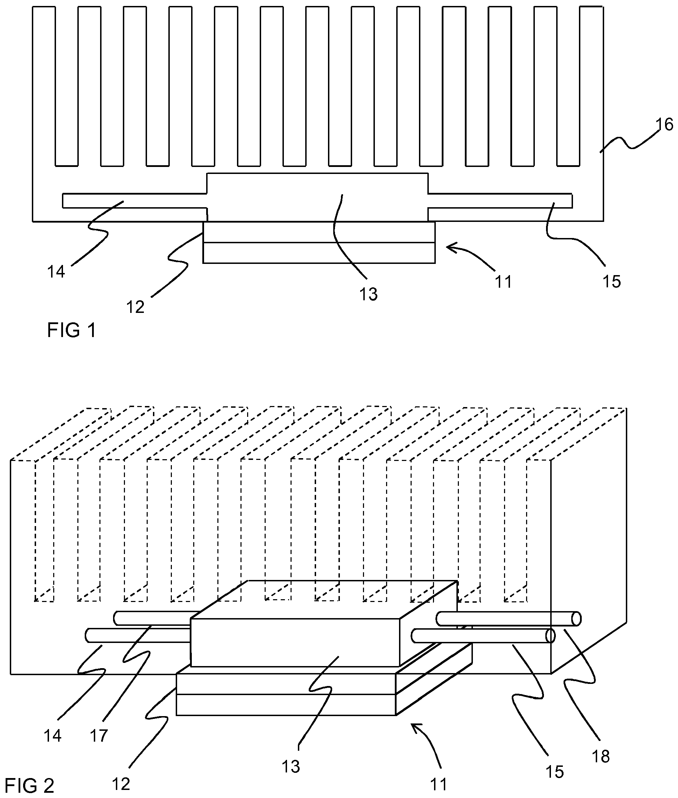

Figure 1 is a cross section of an example of a cooled power electric assembly. Figure 1 shows a power electric assembly with a power electronic module 11. The power electronic module has multiple of power electronic switch components embedded in the module. The power electronic module comprises also a base plate 12 through which the heat from the power electronic switch components is mainly removed.

Figure 1 also shows a vapour chamber 13 having multiple of condenser pipes 14, 15 in fluid communication with the vapour chamber 13. The vapour chamber 13 and the condenser pipes 14, 15 are in fluid communication such that vapour chamber and the condenser pipes 14, 15 form a closed volume, that is, the working fluid inside the vapour chamber can move inside the volume defined by the vapour chamber and the condensing pipes.

Figure 1 also shows a mounting plate 16 having an intend or a recess for receiving the vapour chamber and suitable apertures for receiving the condenser pipes. The power electronic module is attached to the mounting plate so that heat from the base plate of the power semiconductor module is transferred to the vapour chamber.

In the example of Figure 1, the condenser pipes 14, 15 are situated inside the mounting plate and in the example, the mounting plate acts as a cooling element and the condenser pipes are releasing heat to the mounting plate. According to the example of Figure 1, the mounting plate comprises also cooling fins which enhance the removal of heat from the mounting plate.

As shown in Figure 1, the vapour chamber is placed in a recess that is provided in the mounting plate. In the example, the bottom surface of the vapour chamber and the bottom surface of the mounting plate are at the same level. Thus when the vapour chamber is situated in the recess of the mounting plate, the bottom surfaces of the vapour chamber and the mounting plate form a substantially even surface.

The base plate of a power electronic module has a surface that is attached against the vapour chamber. These mating surfaces have substantially equal area, meaning that the bottom surface of the vapour chamber is nearly as large as the heat transferring surface of the power electronic module. Large contact area between the vapour chamber and the base plate ensures that heat is transferred effectively.

The power electronic module 11 is mechanically attached to the mounting plate 16 using screws, bolts or any other similar mechanical fastening means. When the module is tightly attached to the mounting plate, the vapour chamber 13 is pressed both against the mounting plate 16 and the base plate 12 of the power electronic module. For the attachment of the power electronic module with screws or bolts that penetrate through the module to the mounting plate, the area of the module has to be somewhat larger than the area of the vapour chamber.

Figure 2 shows a perspective view of the example of Figure 1. From the perspective view it can be seen that the example comprises four condenser pipes 14, 15, 17, 18 that extend inside the mounting plate. Further, in Figure 2 the shape of the vapour chamber is shown to be a rectangular prism for simplicity, and the shape may be any other suitable shape that can be placed in a correspondingly shaped recess of the mounting plate.

As the vapour chamber and the condenser pipes attached to the vapour chamber are a single entity, the mounting plate has to be machined to receive the vapour chamber with the condenser pipes. In connection with the example of Figure 1 this means that the mounting plate includes grooves or apertures that are provided to the bottom surface of the mounting plate for receiving the condenser pipes together with the vapour chamber. In other words, the mounting plate is machined in such a manner that the entity formed by the vapour chamber and the condenser pipes are fitted to the mounting plate. As shown in Figure 1, the condenser pipes are not situated in the surface of the mounting plate. The volume between the condenser pipes and the bottom surface of the mounting plate is preferably filled with resin or other suitable substance. However, the condenser pipes may also be situated in the bottom surface of the mounting plate such that the manufacture of the assembly is simpler.

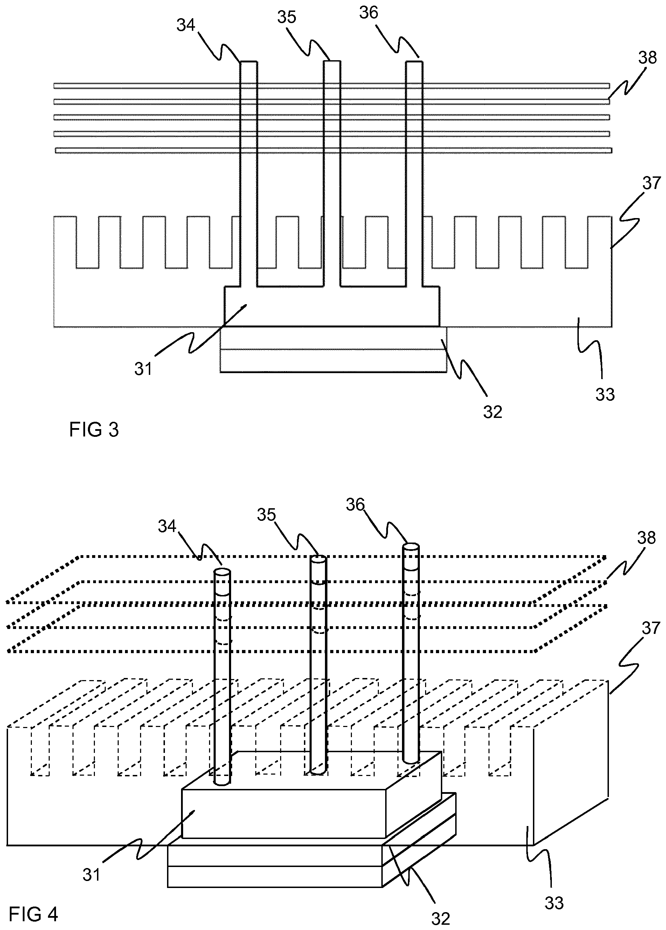

Figure 3 shows another example of a cooling arrangement. In the example of Figure 3, vapour chamber 31 is attached similarly between the base plate 32 of the power electronic module and the mounting plate 33 as in the embodiment of Figure 1. That is, a recess is formed to the mounting plate 33. The recess is dimensioned to receive a vapour chamber 31 such that the bottom surface of the vapour chamber can be contacted with a flat surface of the bottom of the base plate 32 of the power electronic component. The bottom surface of the vapour chamber and the surface of the mounting plate are substantially at the same level.

In the example of Figure 3, the multiple of condenser pipes 34, 35, 36 are extending through the mounting plate 33 and extend outside the mounting plate. As the condenser pipes are in the perpendicular direction with respect to the top surface of the vapour chamber, the installation of the vapour chamber together with the condenser pipes to the assembly is straightforward. Holes or apertures for the condenser pipes are drilled to the mounting plate to correct positions, and the multiple of condenser pipes are led through the holes such that the vapour chamber is also positioned to the recess of the mounting plate. The power electronic module is then fastened to the mounting plate for producing tight thermal coupling.

The mounting plate is shown in Figure 3 with cooling fins 37, but as the condenser pipes are extending through the mounting plate removing the heat outside the mounting plate, the cooling fins are not required for the cooling of the power electronic module. According to the example of Figure 3, the multiple of condenser pipes are equipped with cooling fins 38 attached to the multiple of condenser pipes 34, 35, 36. The cooling fins help in removing heat from the pipes and thereby increase the heat removal from the power electronic module. In connection with cooling fins a forced air cooling is preferably used although natural air cooling is also an option. With forced air cooling a blower or a fan is used to move air through the cooling fins thereby increasing the heat transfer from the fins to the surroundings.

The cooling fins 38 attached to the multiple of condenser pipes may include flow channels for liquid cooling. When using liquid to remove heat from the condenser pipes, the heat transfer from the power electronic module is increased.

Figure 4 shows the example of Figure 3 is perspective view for better understanding the structure of the embodiment.

According to another example, the vapour chamber is situated in the upper surface of the mounting plate. In such an example the base plate of the power electronic module is in tight contact with the bottom surface of the mounting plate, and the mounting plate transfers heat from the base plate of the power electronic module to the vapour chamber. The mounting plate transfers and spreads the heat from the base plate, and the base plate is held in a substantially uniform temperature.

In the example of Figure 1 the condenser pipes are shown inside the mounting plate whereas in the example of Figure 3 the condenser pipes are extending outside the mounting plate. In another example, at least one condenser pipe is situated inside the mounting plate and at least one condenser pipe is extending outside the mounting plate. It is thus a design option to have condenser pipes inside the mounting plate, extending outside the mounting plate or both the previous.

The vapour chamber and the condenser pipes of the invention are preferably formed from copper, although the selection of material is not limited to copper. Other metals or metal alloys can also be used. The mounting plate of the invention is preferably formed of aluminium.

The entity formed by the vapour chamber and the multiple of condenser pipes holds a working fluid inside the volume defined by said vapour chamber and the multiple of condenser pipes. The working fluid may by water or any other suitable fluid which is able to change its phase from liquid to gas and vice versa when heated and cooled. The liquid phase fluid in vapour chamber evaporates by the effect of heat from the power electronic module. The evaporated fluid flows to a cooler place inside the enclosure and condenses back to liquid thereby removing heat from the enclosure. The liquid phase fluid flows back to the vapour chamber and the heat removing process continues. When the condenser pipes are equipped with cooling fins, the condensing area of the pipes is kept at a lower temperature. The increased temperature difference between the evaporation zone and the condensing zone increase the heat transfer rate.

The vapour chamber operates as an evaporator changing the phase of the fluid from liquid to gas with the aid of the heat from the power electronic module. The multiple of condenser pipes, on the other hand, operate as condensers releasing heat to the surroundings of the condenser pipes.

The inner structure of the vapour chamber may be a porous wick structure which increases the evaporation of the fluid inside the vapour chamber. The inner surface of the multiple of condenser pipes may include a copper powder sintering, grooved structure or copper mesh, for example. The selection of the wick of the vapour chamber and the multiple of condenser pipes may be carried out based on design and intended use.

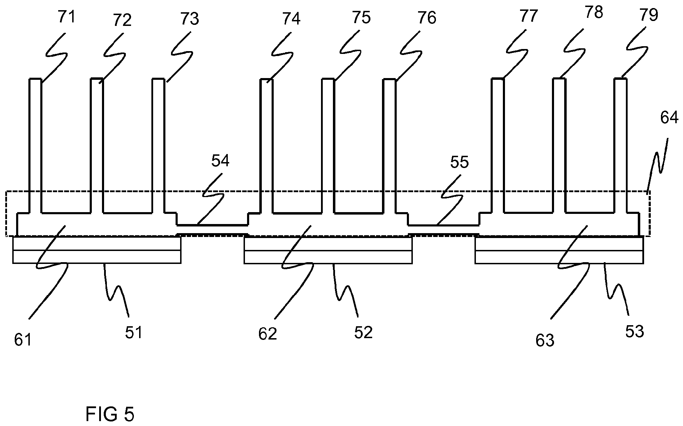

According to the embodiment of the invention shown in Figure 5, a vapour chamber is connected to another vapour chamber with one or more connecting pipes. The connecting pipes connecting the vapour chambers are manufactured in similar manner as the condenser pipes of the illustrative examples.

Further, in the embodiment multiple of power electronic modules are embedded in a mounting plate 64 and each of the power electronic modules are cooled using respective vapour chambers. The embodiment also comprises condenser pipes for releasing the heat in the manner described above. An example of the embodiment is shown in Figure 5 in which three power electronic modules 51, 52, 53 are cooled using three vapour chambers 61, 62, 63 with multiple of condenser pipes 71, 72, 73, 74, 75, 76, 77, 78, 79. The connecting pipes 54, 55 connecting the vapour chambers 61, 62, 63 connect the inner volumes of the vapour chambers and the condenser pipes. As the working fluid can move inside the entity formed by the vapour chambers, connecting pipes and condenser pipes, the three separate power electronic modules are cooled substantially in a uniform manner. Each of the three separate power electronic modules of Figure 5 may, for example, comprise the power electronic switches of one phase output. In such a case the output switches are kept in a substantially equal temperature.

According to an embodiment of the invention, a thermal interface material (TIM) is provided on top of the base plate of the power electronic module. When the power electronic module is attached to the mounting plate, the TIM is pressed against the abutting surfaces and enhancing the transfer of heat from the base plate. As the vapour chamber may be situated in the top or bottom surface of the mounting plate, the TIM is placed either between the base plate and the vapour chamber or between the base plate and the mounting plate. In each case, the TIM decreases the thermal resistance from the base plate.

The thermal interface material is preferably in a form a separate layer that can be installed between the heat releasing base plate and heat receiving vapour chamber or mounting plate. The TIM layer is preferably a carbon based material layer. The carbon based material layer is adapted to spread the heat generated by the semiconductor power electronic switch components in addition to transferring the heat to the cooling arrangement.

The carbon based material is preferably in form of a soft layer having a thickness ranging from 75 µm to 250 µm. The carbon based material is preferably natural graphite, pyrolytic graphite or synthetic graphite.

The softness and thickness of the carbon based material allows it to adapt and fill sufficiently gaps between surfaces of the base plate of the power electronic module and the vapour chamber or mounting plate during the attachment of the module to the abutting surface.

The mounting plate is used in the embodiments for attachment of the power electronic modules. As mentioned above, the power electronic module is firmly attached to the mounting plate for ensuring tight contact to increase the transfer of heat from the base plate of the power electronic module. The mounting plate may also act as a cooling element and may comprise cooling fins. Further, other electrical components may be attached to the mounting plate for fastening the components and for cooling the components.

The mounting plate may also be used in a power electronic device having the power electronic assembly to support the mechanical structure of the device. The mounting plate may, for example, extend inside the power electronic device between the inner walls of the device thereby giving support to the mechanical structure. Further, the mounting plate may separate different compartments inside the device thereby producing a hotter and a cooler compartments or clean air and dirty air compartments, for example.

The invention provides a power electronic assembly with cooling in a compact size. As the heat is effectively removed from a base plate of a power electronic assembly using vapour chamber with condenser pipes, a heat sink is not necessarily needed. Typically heat sinks have been substantially large aluminium blocks with cooling fins. In the present disclosure the mounting plate is provided for accommodating the vapour chamber, and the mounting plate can be only slightly thicker than the vapour chamber.

An example of a method of producing power electronic assembly comprises providing a vapour chamber having multiple of condenser pipes in fluid communication with the vapour chamber. The method further comprises providing a mounting plate having an indent or a recess for receiving the vapour chamber and multiple of apertures for receiving the multiple of condenser pipes. Further in the method the vapour chamber having multiple of condenser pipes is attached to the mounting plate, and a power electronic module comprising a base plate is attached to a surface of either the vapour chamber or mounting plate such that the base plate is in contact with a mating surface of the mounting plate or of the vapour chamber. The method produces an example of a cooling assembly.

The present invention relates also to a converter device which comprises the features of the power electronic assembly. The converter device having the power electronic assembly is cooled in efficient manner. In a converter device, the main switches are provided with the power electronic module and the main switches are thereby cooled in the manner described above. The converter device is more specifically an inverter device. The power electronic assembly of the present disclosure enables to produce a compact size converter device.

## Claims

1. A power electronic assembly comprising a power electronic module (11) incorporating multiple of semiconductor power electronic switch components, the power electronic module comprising a base plate (12),
a vapour chamber (13) having multiple of condenser pipes (14, 15; 34, 35, 36) in fluid communication with the vapour chamber (13), the vapour chamber and the multiple of condenser pipes (14, 15) forming a closed volume and enclosing a working fluid,
a mounting plate (16) having an indent for receiving the vapour chamber and multiple of apertures for receiving the multiple of condenser pipes,
wherein the power electronic module (11) is attached to the mounting plate (16) to transfer heat from the base plate (12) of the power electronic module to the vapour chamber (13), **characterized in that** the assembly comprises at least two vapour chambers (61, 62, 63) which are connected with one or more connecting pipes (54, 55), and each of the vapour chambers comprises multiple of condenser pipes, the at least two vapour chambers, the one or more connecting pipes and the multiple of condenser pipes forming a closed volume and enclosing a working fluid.

2. A power electronic assembly according to claim 1, wherein the multiple of condenser pipes are arranged inside the mounting plate.

3. A power electronic assembly according to claim 1, wherein the multiple of condenser pipes are arranged to extend outside the mounting plate.

4. A power electronic assembly according to claim 3, wherein the multiple of condenser pipes are arranged to extend through the mounting plate.

5. A power electronic assembly according to claim 3 or 4, wherein cooling fins (38) are attached to the condenser pipes (34, 35, 36).

6. A power electronic assembly according to claim 5, wherein the cooling fins are liquid cooled or cooled with natural or forced air.

7. A power electronic assembly according to any one of the previous claims 1 to 6, wherein the base plate (16) of the power semiconductor module is attached against a surface of the vapour chamber.

8. A power electronic assembly according to any one of the previous claims 1 to 6, wherein the base plate (16) of the power semiconductor module is attached against a surface of the mounting plate.

9. A power electronic assembly according to any one of the previous claims, wherein a thermal interface material is provided between the base plate and a mating surface of the vapour chamber for enhancing the transfer of heat from the base plate to the vapour chamber.

10. A power electronic assembly according to claim 9, wherein the thermal interface material is a carbon based layer.

11. Converter device comprising a power electronic assembly according to any of the previous claims 1 to 10.

## Patentansprüche

1. Leistungselektronikbaugruppe, die ein Leistungselektronikmodul (11) umfasst, in dem mehrere Leistungselektronik-Halbleiterschaltkomponenten integriert sind, wobei das Leistungselektronikmodul Folgendes umfasst:
eine Basisplatte (12),
eine Dampfkammer (13) mit mehreren Verflüssigerrohren (14, 15; 34, 35, 36) in fluidtechnischer Verbindung mit der Dampfkammer (13), wobei die Dampfkammer und die mehreren Verflüssigerrohre (14, 15) ein geschlossenes Volumen bilden und ein Arbeitsfluid einschließen,
eine Montageplatte (16) mit einer Vertiefung zur Aufnahme der Dampfkammer und mehreren Öffnungen zur Aufnahme der mehreren Verflüssigerrohre,
wobei das Leistungselektronikmodul (11) an der Montageplatte (16) befestigt ist, um Wärme von der Basisplatte (12) des Leistungselektronikmoduls zu der Dampfkammer (13) zu übertragen,
**dadurch gekennzeichnet, dass** die Baugruppe mindestens zwei Dampfkammern (61, 62, 63) umfasst, die mit einem oder mehreren Verbindungsrohren (54, 55) verbunden sind, und jede der Dampfkammern mehrere Verflüssigerrohre umfasst, wobei die mindestens zwei Dampfkammern, das eine oder die mehreren Verbindungsrohre und die mehreren Verflüssigerrohre ein geschlossenes Volumen bilden und ein Arbeitsfluid einschließen.

2. Leistungselektronikbaugruppe nach Anspruch 1, wobei die mehreren Verflüssigerrohre innerhalb der Montageplatte angeordnet sind.

3. Leistungselektronikbaugruppe nach Anspruch 1, wobei die mehreren Verflüssigerrohre dahingehend angeordnet sind, sich nach außerhalb der Montageplatte zu erstrecken.

4. Leistungselektronikbaugruppe nach Anspruch 3, wobei die mehreren Verflüssigerrohre dahingehend angeordnet sind, sich durch die Montageplatte zu erstrecken.

5. Leistungselektronikbaugruppe nach Anspruch 3 oder 4, wobei Kühlrippen (38) an den Verflüssigerrohren (34, 35, 36) befestigt sind.

6. Leistungselektronikbaugruppe nach Anspruch 5, wobei die Kühlrippen mittels Flüssigkeit oder mittels Umgebungs- oder Zwangsluft gekühlt werden.

7. Leistungselektronikbaugruppe nach einem der vorhergehenden Ansprüche 1 bis 6, wobei die Basisplatte (16) des Leistungshalbleitermoduls an einer Oberfläche der Dampfkammer anliegend befestigt ist.

8. Leistungselektronikbaugruppe nach einem der vorhergehenden Ansprüche 1 bis 6, wobei die Basisplatte (16) des Leistungshalbleitermoduls an einer Oberfläche der Montageplatte anliegend befestigt ist.

9. Leistungselektronikbaugruppe nach einem der vorhergehenden Ansprüche, wobei ein Wärmeübergangsmaterial zwischen der Basisplatte und einer Passoberfläche der Dampfkammer zur Verbesserung der Wärmeübertragung von der Basisplatte zu der Dampfkammer bereitgestellt ist.

10. Leistungselektronikbaugruppe nach Anspruch 9, wobei es sich bei dem Wärmeübergangsmaterial um eine Schicht auf Kohlenstoffbasis handelt.

11. Umrichtervorrichtung, die eine Leistungselektronikbaugruppe nach einem der vorhergehenden Ansprüche 1 bis 10 umfasst.

## Revendications

1. Ensemble électronique de puissance comportant un module électronique (11) de puissance incorporant une multiplicité de composants commutateurs électroniques de puissance à semiconducteurs, le module électronique de puissance comportant une plaque (12) de base,
une chambre (13) à vapeur dotée d'une multiplicité de tuyaux (14, 15; 34, 35, 36) de condenseur en communication fluidique avec la chambre (13) à vapeur, la chambre à vapeur et la multiplicité de tuyaux (14, 15) de condenseur formant un volume fermé et renfermant un fluide de travail,
une plaque (16) de montage présentant une indentation destinée à recevoir la chambre à vapeur et une multiplicité d'ouvertures destinées à recevoir la multiplicité de tuyaux de condenseur,
le module électronique (11) de puissance étant fixé à la plaque (16) de montage pour transférer de la chaleur de la plaque (12) de base du module électronique de puissance à la chambre (13) à vapeur,
**caractérisé en ce que** l'ensemble comporte au moins deux chambres (61, 62, 63) à vapeur qui sont raccordées à l'aide d'un ou de plusieurs tuyaux (54, 55) de raccordement, et **en ce que** chacune des chambres à vapeur comporte une multiplicité de tuyaux de condenseur, lesdites au moins deux chambres à vapeur, le ou les tuyaux de raccordement et la multiplicité de tuyaux de condenseur formant un volume fermé et renfermant un fluide de travail.

2. Ensemble électronique de puissance selon la revendication 1, la multiplicité de tuyaux de condenseur étant agencée à l'intérieur de la plaque de montage.

3. Ensemble électronique de puissance selon la revendication 1, la multiplicité de tuyaux de condenseur étant agencée pour s'étendre à l'extérieur de la plaque de montage.

4. Ensemble électronique de puissance selon la revendication 3, la multiplicité de tuyaux de condenseur étant agencée pour s'étendre à travers la plaque de montage.

5. Ensemble électronique de puissance selon la revendication 3 ou 4, des ailettes (38) de refroidissement étant fixées aux tuyaux (34, 35, 36) de condenseur.

6. Ensemble électronique de puissance selon la revendication 5, les ailettes de refroidissement étant refroidies par liquide ou refroidies par de l'air naturel ou forcé.

7. Ensemble électronique de puissance selon l'une quelconque des revendications 1 à 6 qui précèdent, la plaque (16) de base du module à semiconducteurs de puissance étant fixée contre une surface de la chambre à vapeur.

8. Ensemble électronique de puissance selon l'une quelconque des revendications 1 à 6 qui précèdent, la plaque (16) de base du module à semiconducteurs de puissance étant fixée contre une surface de la plaque de montage.

9. Ensemble électronique de puissance selon l'une quelconque des revendications précédentes, un matériau d'interface thermique étant placé entre la plaque de base et une surface complémentaire de la chambre à vapeur pour renforcer le transfert de chaleur de la plaque de base à la chambre à vapeur.

10. Ensemble électronique de puissance selon la revendication 9, le matériau d'interface thermique étant une couche à base de carbone.

11. Dispositif convertisseur comportant un ensemble électronique de puissance selon l'une quelconque des revendications 1 à 10 qui précèdent.
